# DEMANDE DE BREVET EUROPEEN

(11) **EP 4 386 634 A1**
(43) Date de publication de la demande: **19.06.2024**
(21) Numéro de dépôt: 23215461.7
(22) Date de dépôt: 11.12.2023
(51) Int. Cl.: G06N 10/40, H01L 29/06, H01L 29/66, H01L 29/40, H01L 29/41, H01L 29/423, H01L 29/76, B82Y 10/00

(54) **ELECTRODES D'ÉCHANGE POUR RÉSEAU D'ILOTS QUANTIQUES**

(30) Priorité: 14.12.2022 FR 2213369
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR); BERTRAND, Benoit, 38054 GRENOBLE CEDEX 09 (FR); NOWAK, Etienne, 38054 GRENOBLE CEDEX 09 (FR)
(74) Mandataire: Brevalex

(57) **Abrégé**

Réalisation d'un dispositif électronique quantique comprenant :
- un substrat (10) revêtu d'au moins un bloc semi-conducteur (14),
- des zones d'isolation (15A, 15B) de part et d'autre du bloc semi-conducteur (14),
- des électrodes de grille (22a, 22b, 22c, 22d, 22e) avant sur des régions (14A, 14B, 14C, 14D, 14E) du bloc semi-conducteur (14) formant chacune un ilot quantique,
- une ou plusieurs électrodes d'échange (67₁, 67₂, 67₃, 67₄, 67₅, 67₆, 67₇, 67₈,) agencée(s) autour et à distance dudit bloc semi-conducteur (14), au moins une première électrode d'échange (67₁) parmi lesdites électrodes d'échange étant prévue de sorte à permettre de moduler une barrière tunnel entre un premier ilot quantique et un deuxième ilot quantique cette première électrode d'échange (67₁) étant formée d'un premier plot conducteur traversant une couche isolante (50) recouvrant ledit bloc semi-conducteur (14), lesdites zones d'isolation (15A, 15B) et les électrodes de grille, ledit premier plot conducteur ayant une extrémité dite « inférieure » disposée en contact avec la première zone d'isolation (15A).

## Description

### DOMAINE TECHNIQUE ET ÉTAT DE LA TECHNIQUE ANTÉRIEURE

La présente demande concerne le domaine des dispositifs électroniques quantiques à bits quantiques (également appelés quantum bits ou « qubits » ou « Qbits ») formés à partir de régions d'ilots quantiques semi-conducteurs et utilisant, outre des électrodes de grille de contrôle dites « avant » et situées au-dessus des ilots, une ou plusieurs électrodes d'échanges pour permettre un couplage entre deux ilots ou entre un ilot et un réservoir de charges.

Les îlots quantiques (parfois également appelées boîtes ou points quantiques) forment des éléments de base d'un dispositif électronique quantique. Les îlots quantiques sont typiquement formés dans une région de matériau semi-conducteur dans laquelle des puits de potentiel sont mis en oeuvre pour confiner des porteurs, électrons ou trous, dans les trois dimensions de l'espace. Une information quantique est alors codée par le biais du spin du porteur. On parle alors de qubits de spin.

Les dispositifs quantiques à qubits de spin formés à l'aide d'une région semi-conductrice ont pour avantage de permettre une fabrication d'une densité de qubits importante et de pouvoir co-intégrer ces qubits avec d'autres composants, comme par exemple des transistors.

Selon une approche, des électrons sont confinés par effet de champ sous des électrodes de grilles semblables à celles des structures de transistors et l'information est encodée dans le spin de ces électrons. Ces grilles dites « avant » sont disposées au-dessus des ilots quantiques.

Pour permettre un contrôle amélioré et pouvoir réaliser un couplage tunnel entre ilots voisins et pouvoir ainsi modifier une barrière tunnel entre ces ilots quantiques voisins, des électrodes supplémentaires, appelées électrodes d'échange peuvent être prévues.

Ainsi, le document « A Single-Electron Injection Device for CMOS Charge Qubits Implemented in 22-nm FD-SOI » de Bashir et al., IEEE SOLID-STATE CIRCUITS LETTERS, VOL. 3, 2020, prévoit par exemple une électrode supplémentaire supérieure formée au-dessus des électrodes de grilles et au niveau du premier niveau métallique d'interconnexions afin de contrôler le couplage tunnel entre deux ilots adjacents.

L'efficacité d'une telle électrode supplémentaire, en termes de modulation de potentiel qu'elle permet de réaliser, s'avère insuffisante. Cela est dû notamment à la distance trop importante entre l'électrode supplémentaire située dans le premier niveau métallique et la couche semi-conductrice ou « zone active » dans laquelle les qubits sont formés.

Cela est dû également à un effet de blindage électrostatique du fait que les grilles sont situées dans l'empilement entre l'électrode supplémentaire au premier niveau métallique et la zone active.

Le document « A new FDSOI spin qubit platform with 40 nm effective control pitch », de T. Bédécarrats et al., IEDM 2021 prévoit également des électrodes d'échange appelées « J-gates » pour contrôler le couplage tunnel entre deux ilots quantiques adjacents. Ces électrodes d'échange sont cette fois sous forme de plots conducteurs disposés au-dessus et en regard de la zone active. Le contrôle du couplage entre ilots est amélioré dans la mesure où l'extrémité inférieure des plots est rapprochée mais la mise en oeuvre de telles électrodes pose des problèmes de coûts et des difficultés de positionnement des plots. Il est en effet difficile de disposer ces plots à distance suffisamment faible de la zone active pour améliorer le couplage tout en évitant de rentrer en contact avec les électrodes de grille et les ilots eux-mêmes. Un effet de « blindage » par les grilles persiste avec cette configuration.

Il se pose le problème de réaliser un nouveau dispositif quantique avec une ou plusieurs électrodes d'échanges et qui soit amélioré vis-à-vis d'au moins un des inconvénients mentionnés ci-dessus.

### EXPOSÉ DE L'INVENTION

Selon un aspect, la présente invention concerne un dispositif électronique quantique comprenant :
- un substrat revêtu d'au moins un bloc semi-conducteur, ledit bloc semi-conducteur s'étendant principalement dans une première direction, ledit bloc semi-conducteur comprenant une couche semi-conductrice ;
- des zones d'isolation agencées de part et d'autre de la couche semi-conductrice dudit bloc semi-conducteur,
- une pluralité de grilles avant, chaque grille avant comprenant une partie s'étendant sur des régions de la couche semi-conductrice dudit bloc semi-conducteur, chacune desdites régions formant un ilot quantique,
- une ou plusieurs électrodes d'échange, lesdites une ou plusieurs électrodes d'échange étant agencée(s) en regard et au-dessus d'une desdites zones d'isolation et chaque électrode d'échange est dotée d'une extrémité inférieure en contact directement avec un matériau isolant de cette zone d'isolation ou disposé sur cette zone d'isolation.

Un tel agencement de l'électrode d'échange permet de se rapprocher de la zone active et par conséquent des ilots adjacents ou de l'ilot quantique et du réservoir de dopants sans subir un effet d'écrantage des grilles avant. Avec de telles électrodes d'échange, un contrôle amélioré de la barrière tunnel entre ilots adjacents ou entre ilot quantique et réservoir de dopants peut être alors obtenu.

La réalisation de telles électrodes d'échange peut être également effectuée sans venir risquer de prendre contact sur le bloc semi-conducteur.

Avantageusement, au moins une électrode d'échange ou chaque électrode d'échange peut être formée d'un plot conducteur ou via conducteur, autrement dit d'un élément conducteur s'étendant verticalement ou orthogonalement à un plan principal du substrat et dotée d'une extrémité correspondant à ladite extrémité inférieure. La ou les électrodes d'échange est ou sont de préférence située(s) en dehors d'une zone dite « zone active » formée par le bloc semi-conducteur. Autrement dit, la ou les électrodes d'échange sont situées en dehors d'une projection verticale du bloc semi-conducteur.

La ou les électrodes d'échange est ou sont de préférence située(s) en dehors d'une zone dite « zone active » formée par le bloc semi-conducteur mais au plus près de celui-ci.

Avantageusement la ou les électrodes d'échanges sont située(s) d'un même côté du substrat que les grilles avant. Autrement dit, la ou les électrodes d'échanges ne sont pas disposés à l'arrière du substrat.

Avantageusement la ou les électrodes d'échanges sont en un matériau qui n'est pas dopé.

Avantageusement, au moins une grille avant ou chaque grille avant comprend une autre partie s'étendant sur une des zones d'isolation.

Avantageusement, au moins une électrode d'échange ou chaque électrode d'échange est disposée entre deux desdites grilles avant.

Le dispositif peut être muni d'au moins une première électrode d'échange parmi lesdites électrodes d'échange s'étend au-dessus de la première zone d'isolation et à distance d'une première région dudit bloc semi-conducteur formant un premier ilot quantique, la première électrode d'échange étant prévue à distance d'une deuxième région dudit bloc semi-conducteur formant un deuxième ilot quantique et de sorte à permettre de moduler une barrière tunnel entre ledit premier ilot quantique et ledit deuxième ilot quantique.

La première électrode d'échange peut être formée d'un plot conducteur, ledit deuxième plot conducteur ayant une extrémité dite « inférieure » disposée en contact avec la deuxième zone d'isolation ou avec un matériau isolant formé sur ladite deuxième zone d'isolation. Le plot conducteur traverse typiquement une couche isolante recouvrant ledit bloc semi-conducteur et les desdites zones d'isolation.

Selon une possibilité de mise en oeuvre, ladite deuxième région dudit bloc semi-conducteurforme un deuxième ilot quantique, la première électrode d'échange étant juxtaposée à une partie dudit bloc semi-conducteur agencée entre ladite première région et ladite deuxième région dudit bloc semi-conducteur.

Selon une mise en oeuvre possible, une deuxième électrode d'échange agencée au-dessus d'une deuxième zone d'isolation et à distance de ladite première région formant un premier ilot quantique et de la deuxième région formant un deuxième ilot quantique de sorte est prévue pour moduler la barrière tunnel entre ledit premier ilot quantique et ledit deuxième ilot quantique, ladite deuxième électrode d'échange étant formée d'un deuxième plot conducteur, ledit deuxième plot conducteur ayant une extrémité dite « inférieure » disposée en contact avec la deuxième zone d'isolation ou avec un matériau isolant formé sur ladite deuxième zone d'isolation.

Selon une possibilité de mise en oeuvre, la première électrode d'échange est agencée entre un premier bloc de grille et un deuxième bloc de grille, le premier bloc de grille et le deuxième bloc de grille s'étendant principalement dans une deuxième direction orthogonale à la première direction.

Selon une mise en oeuvre possible, le dispositif peut comprendre en outre au moins une autre électrode d'échange pour moduler la barrière tunnel entre le deuxième ilot quantique et un troisième ilot quantique formé dans une troisième région du bloc semi-conducteur, l'autre électrode d'échange étant formée d'un troisième plot conducteur traversant, le troisième plot conducteur ayant une extrémité inférieure en contact avec la première zone d'isolation ou la deuxième zone d'isolation ou un matériau isolant disposé sur la première zone d'isolation ou la deuxième zone d'isolation.

Selon une possibilité de mise en oeuvre pour laquelle le troisième plot conducteur peut être disposé au-dessus et en regard de la première zone d'isolation et former une troisième électrode d'échange, le dispositif comprend en outre une quatrième électrode d'échange pour moduler la barrière tunnel entre le deuxième ilot quantique et un troisième ilot quantique, la quatrième électrode d'échange étant formée d'un quatrième plot conducteur au-dessus et en regard de ladite deuxième zone d'isolation.

Selon une possibilité de mise en oeuvre pour laquelle la première électrode d'échange est prévue pour contrôler la barrière tunnel entre le premier ilot quantique et le deuxième ilot quantique, le dispositif peut être doté en outre d'au moins une électrode d'échange supplémentaire prévue pour moduler une barrière tunnel entre un desdits ilots quantiques et un réservoir de charges.

Selon une possibilité de mise en oeuvre, ladite extrémité inférieure de chaque électrode d'échange peut être en contact avec une couche d'arrêt de gravure ou une couche diélectrique dans laquelle des espaceurs isolants des grilles avant sont formés.

Avantageusement, le dispositif peut comprendre en outre des réservoirs de charge formés sur ou dans ledit bloc semi-conducteur, les réservoirs étant agencés de part et d'autre desdites grilles avant.

Avantageusement, le dispositif peut comprendre en outre une pluralité d'électrodes de réservoir de charge, chaque électrode de réservoir de charge contactant un réservoir de charge formé sur ou dans ledit bloc semi-conducteur.

Selon une possibilité de mise en oeuvre, le substrat est un substrat de type semi-conducteur sur isolant, ledit bloc semi-conducteur étant alors formé dans une couche semi-conductrice superficielle du substrat.

Selon une autre possibilité de mise en oeuvre, le substrat est un substrat semi-conducteur massif.

Le bloc semi-conducteur peut être formé par gravure d'une couche semi-conductrice superficielle du substrat ou par gravure d'une couche semi-conductrice déposée sur ce substrat, ou par croissance sur ce substrat.

Selon un autre aspect, la présente invention concerne un procédé de fabrication d'un dispositif électronique quantique tel que défini plus haut.

Selon un autre aspect, la présente invention concerne un procédé de fabrication d'un dispositif quantique comprenant, dans cet ordre, des étapes consistant à :
- former sur un substrat un bloc semi-conducteur, et des zones d'isolation de part et d'autre du bloc semi-conducteur, puis
- former des blocs de grille sur le bloc semi-conducteur, puis,
- former une ou plusieurs électrodes d'échange par :
   - dépôt d'une couche isolante recouvrant le bloc semi-conducteur, les zones d'isolation et les blocs de grille
   - réalisation d'une ou plusieurs ouvertures, au moins une première ouverture traversant la couche isolante et atteignant la première zone d'isolation ou un matériau isolant formé sur la première zone d'isolation
   - dépôt d'au moins un matériau conducteur dans les ouvertures.

Le procédé peut comprendre en outre, préalablement à la formation de la couche isolante, des étapes de :
- dépôt d'au moins une couche diélectrique,
- gravure de la couche diélectrique sur des portions d'extrémité du bloc semi-conducteur agencées de part et d'autre de l'ensemble des blocs de grille et de sorte à conserver ladite couche diélectrique sur une portion centrale du bloc semi-conducteur et à former des espaceurs isolants contre les blocs de grille.

Selon une possibilité de mise en oeuvre des ouvertures, ledit matériau isolant formé sur la première zone d'isolation est celui de ladite couche diélectrique.

Selon une possibilité de mise en oeuvre, le procédé peut comprendre en outre, préalablement à la formation de la couche isolante et après la gravure de la couche diélectrique, la formation de régions dopées sur les portions d'extrémité du bloc semi-conducteur agencées de part et d'autre de l'ensemble des blocs de grille.

Selon une possibilité de mise en oeuvre du procédé, parmi les ouvertures, au moins une autre ouverture dévoile une région dopée du bloc semi-conducteur.

La réalisation de la ou les électrodes d'échange peut être ainsi concomitante à la réalisation de prises de contacts sur les réservoirs de charges.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 illustre un exemple de substrat de départ possible pour mettre en oeuvre un dispositif quantique suivant l'invention.
Les figures 2A et 2B illustrent une réalisation d'un barreau semi-conducteur dans lequel une pluralité d'ilots quantiques est destinée à être formée.
Les figures 3A, 3B et 3C illustrent une mise en oeuvre d'une pluralité de grilles de contrôle électrostatique des ilots quantique.
Les figures 4A, 4B, 5A et 5B illustrent une mise en oeuvre d'une couche diélectrique pour protéger une portion centrale du barreau semi-conducteur dans laquelle les ilots quantiques sont formés.
Les figures 6A et 6B illustrent la mise en oeuvre de réservoirs de charges sur le barreau semi-conducteur et de part et d'autre de la portion centrale du barreau semi-conducteur et de l'ensemble des grilles de contrôle.
Les figures 7, 8A et 8B illustrent la mise en oeuvre de zones d'alliage de métal et de semi-conducteur sur les réservoirs de charges et les grilles afin de former des contacts ohmiques.
Les figure 9A à 11 illustrent la formation d'électrodes d'échange pour permettre un couplage tunnel entre ilots quantiques voisins.
Les figures 12A et 12B illustrent la réalisation d'électrodes d'échange cette fois entre réservoir de dopants et ilot quantique.
Les figures 13A et 13B illustrent une variante de réalisation pour laquelle une portion centrale du bloc semi-conducteur est divisée en deux branches séparées, les ilots quantiques étant formés dans au moins une desdites branches.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « au-dessus », « au-dessous », « arrière », « avant », « périphérique » s'appliquent en considérant que la structure est orientée de la façon illustrée sur les figures.

### EXPOSÉ DÉTAILLÉ DE MODES DE RÉALISATION PARTICULIERS

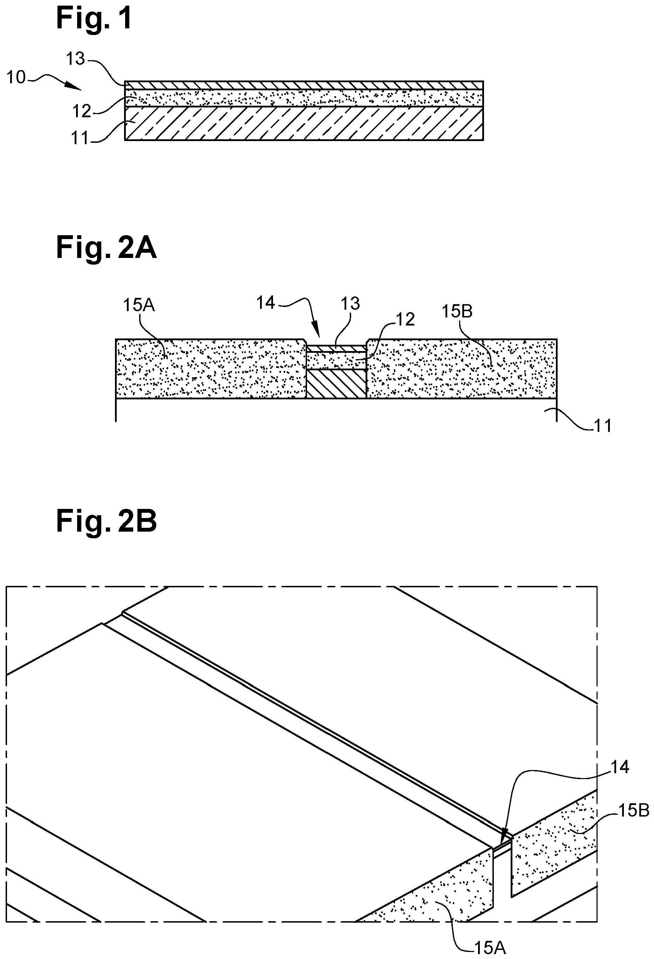

On se réfère tout d'abord à la figure 1 qui donne un exemple de matériau de départ possible pour la réalisation d'un dispositif quantique suivant l'invention et qui se trouve ici sous forme d'un substrat 10 de type semi-conducteur sur isolant.

Le substrat 10 comporte ainsi une couche 11 en support en matériau semi-conducteur, une couche isolante enterrée 12 disposée sur la couche support 11 et une couche superficielle 13 semi-conductrice disposée sur la couche isolante. Le substrat 10 est typiquement un substrat SOI dont la couche superficielle 13 est en silicium, en particulier du ²⁸Si lorsque cette couche est amenée à accueillir des ilots quantiques formant des qubits de spin d'électrons.

La couche isolante 12 et la couche de support 11 sont typiquement, respectivement, une couche en oxyde de silicium communément appelée de « BOX » (pour « Burried Oxide » ou « oxyde enterré ») et une couche semi-conductrice, par exemple à base de silicium. L'épaisseur de la couche superficielle 13 est par exemple comprise entre 5 nm et 50 nm, typiquement de l'ordre de 10 nm. L'épaisseur de la couche isolante enterrée 12 est par exemple comprise entre 15 nm et 150 nm.

D'autres matériaux semi-conducteurs peuvent être envisagés pour la couche semi-conductrice superficielle 13. Pour des qubit de spin de trous, du silicium peut être également employé ou, selon une variante, on peut opter pour une hétérostructure de type SiGe relaxé/Germanium contraint/SiGe relaxé, la couche de qubits de trou étant celle en germanium.

Ensuite, on peut définir dans la couche superficielle 13 au moins un motif de zone active, ici sous forme d'un bloc semi-conducteur 14, typiquement de forme oblongue ou de barreau, par exemple parallélépipédique, et qui s'étend principalement dans une première direction. Cela peut être réalisé par photolithographie et gravure de la couche superficielle 13, en particulier une gravure plasma avec arrêt sur la couche isolante 12.

On forme ensuite des zones d'isolation 15A, 15B de part et d'autre de la zone active. Les zones d'isolation 15A, 15B peuvent être de type STI (pour « Shallow Trench Isolation » ou « tranchées d'isolation peu profondes »). Les zones d'isolation 15A, 15B sont par exemple à base d'oxyde de silicium. Les zones d'isolation 15A, 15B peuvent être réalisées par gravure puis dépôt de matériau isolant. Cela peut être suivi d'une éventuelle planarisation pour retirer une épaisseur de matériau isolant et mettre les faces supérieures des zones d'isolation 15A, 15B au même niveau ou sensiblement au même niveau que la face supérieure du bloc semi-conducteur 14.

Dans l'exemple de réalisation particulier illustré sur les figures 2A, 2B (donnant respectivement une vue en coupe et une vue en perspective) un faible écart de niveau, par exemple compris entre 0 et 20 nm, est prévu entre d'une part les faces supérieures des zones d'isolation 15A, 15B et d'autre part la face supérieure du bloc semi-conducteur 14.

On réalise ensuite un empilement de grille recouvrant le bloc semi-conducteur 14 et les zones d'isolation 15A, 15B. Cet empilement est typiquement formé d'au moins une couche de diélectrique de grille et d'une ou plusieurs couches de matériau(x) de grille semi-conducteur(s) dopé et/ou métallique(s).

Par exemple le diélectrique de grille est formé d'un oxyde de silicium. Un diélectrique dit « high-k », autrement dit de constante diélectrique k élevée tel que par exemple du HfOz peut être également employé. Le diélectrique peut lui-même être surmonté d'une couche métallique telle que par exemple du TiN surmontée d'une couche de polysilicium dopé pour former les matériaux de grille.

L'empilement de grille peut être revêtu d'au moins une couche de masquage, en particulier d'au moins une couche de masque dur formée typiquement d'au moins une couche isolante, par exemple en SiN et/ou en SiO₂.

On définit ensuite par gravure dans la couche de masquage une pluralité de blocs 24a, 24c, 24d, 24e de masquage afin de réaliser une pluralité de blocs 22a, 22b, 22c, 22d, 22e distincts dans l'empilement de grille. Des gravures anisotropes et en particulier à l'aide d'un plasma sont effectuées pour réaliser les blocs 24a, 24b, 24c, 24d, 24e de masquage, puis les blocs de grilles 22a, ..., 22e distincts sous ces derniers et reproduisant les motifs de ces derniers.

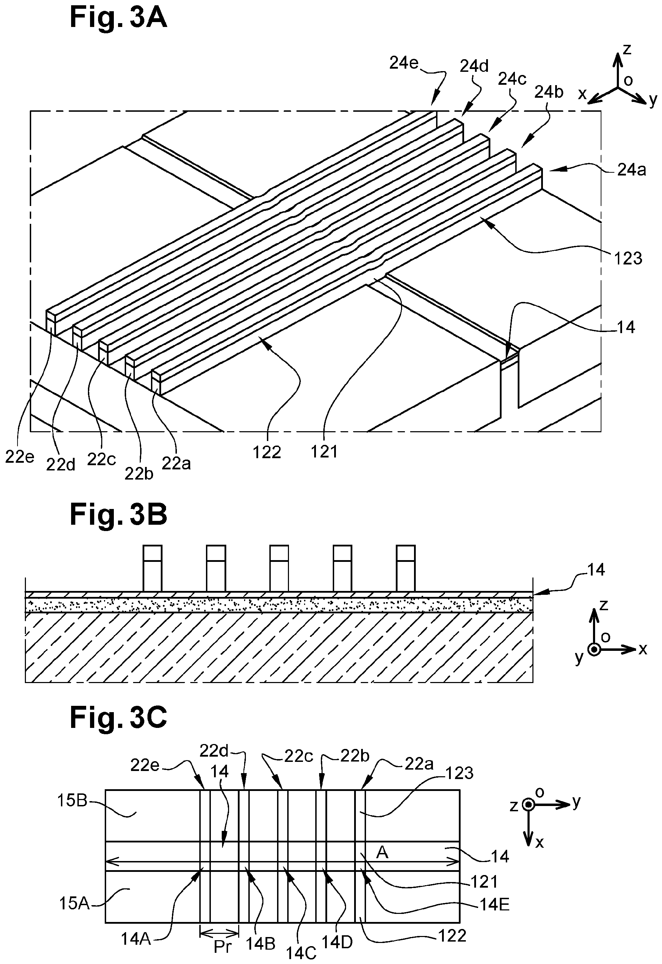

Une structure obtenue à l'issue de cette étape est illustrée sur les figures 3A, 3B, donnant respectivement une vue en perspective, une vue en coupe selon un axe A (donné sur la vue de dessus de la figure 3C). Les blocs de grilles 22a, ..., 22e ont dans cet exemple chacun une forme de barreau parallélépipédique. Ces blocs de grilles 22a, ..., 22e s'étendent typiquement dans une direction (mesurée parallèlement à l'axe x du repère orthogonal [O ; x ; y ; z]) orthogonale à la direction dans laquelle le bloc semi-conducteur 14 s'étend. Ces blocs de grilles 22a, ..., 22e s'étendent ici parallèlement à un plan principal du substrat 10 (autrement dit un plan passant par le substrat et parallèle au plan [O ; x ; y ]). Les blocs 22a, ..., 22e de grille sont de préférence régulièrement espacés avec une répartition dense, par exemple telle que le pas de répartition Pr est de l'ordre de 20 à 100 nm. Chaque bloc de grille 22a, 22b, 22c, 22d, 22e comprend une portion centrale 121 située sur une région du bloc semi-conducteur 14, cette région étant destinée à former un ilot quantique. Chaque bloc de grille 22a, 22b, 22c, 22d, 22e comporte ici également des portions 123, 122 d'extrémité de part et d'autre de la portion centrale 121 et situées respectivement sur la zone d'isolation 15B et la zone d'isolation 15A. On a donc ici dans cet exemple autant d'ilots 14A, 14B, 14C, 14D, 14E quantiques que de blocs de grilles.

Chaque bloc de grille peut être amené à former une électrode de grille dite « avant ». Chaque grille avant peut être éventuellement indépendante et non-connectée aux autres grilles avant et peut être ainsi commandée indépendamment des autre grilles avant.

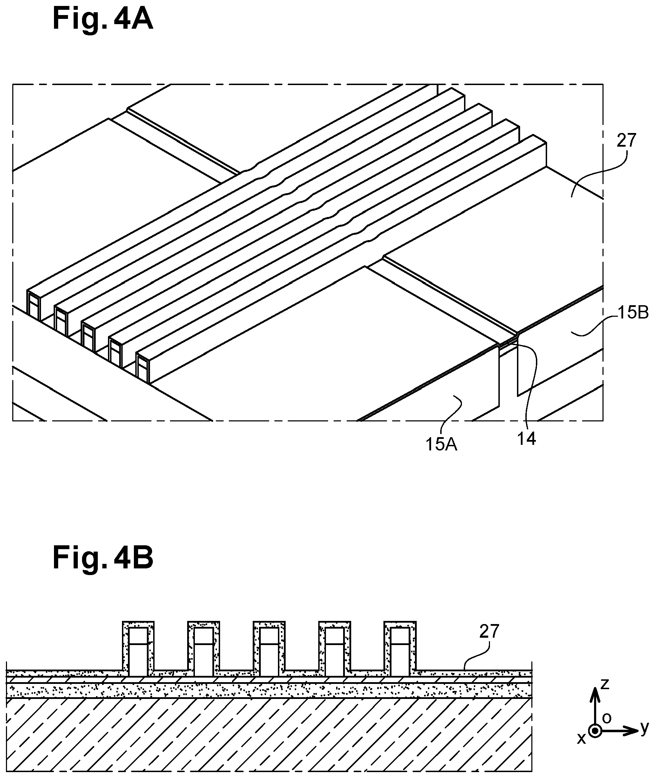

Un masque diélectrique 27 peut être ensuite formé sur et entre les blocs de grille. Le masque diélectrique 27 peut être ici réalisé par dépôt d'une couche diélectrique, effectué de sorte à recouvrir le bloc semi-conducteur 14, les blocs 22a, ..., 22e de grilles et les espaces entre les blocs 22a, ..., 22e de grilles. Dans l'exemple illustré sur les figures 4A, 4B, (donnant respectivement une vue en perspective, une vue en coupe selon l'axe A longitudinal), le masque diélectrique 27 recouvre également les zones d'isolation 15A, 15B.

Le matériau du masque diélectrique 27 est par exemple choisi parmi l'un des matériaux suivants : SiO2, SiN, SiCO, SiBCN, SiOCN. Le procédé de dépôt du masque diélectrique 27 est de préférence conforme, et en particulier de type ALD (pour « Atomic Layer Déposition » ou « dépôt de couche atomique ») afin de remplir les espaces inter-grilles sans création de défaut de remplissage.

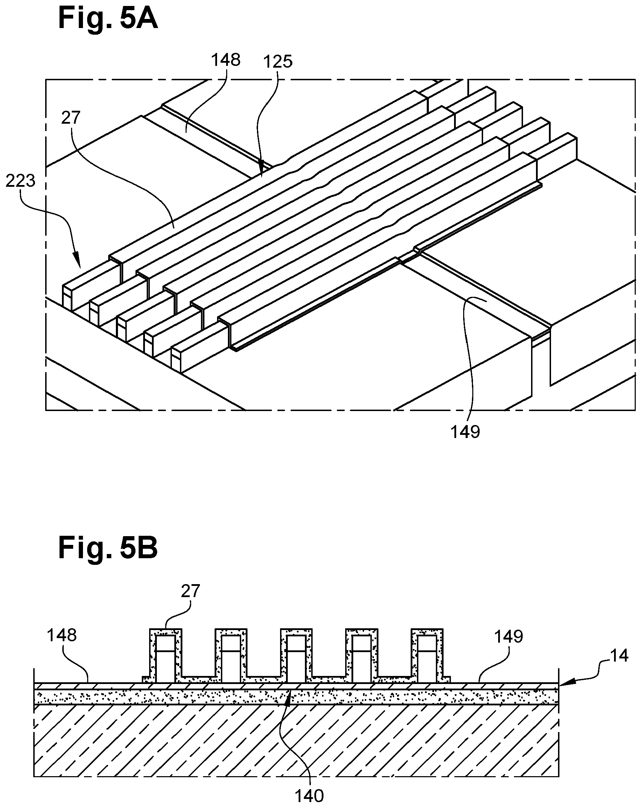

On effectue ensuite (figures 5A, 5B donnant respectivement une vue en perspective, une vue en coupe selon l'axe longitudinal A), une gravure de cette couche diélectrique de sorte à ne préserver le masque diélectrique 27 que sur une région 125 des blocs 22a, ..., 22e de grille qui comprend la portion centrale 121 et une partie des portions 122, 123 d'extrémité des blocs de grille. Le masque diélectrique 27 est également préservé entre les régions 125 respectives de ces blocs 22a, ..., 22e de grille.

On retire le masque diélectrique 27 de faces supérieures de portions d'extrémité 223 des blocs 22a, ..., 22e et de portions 148, 149 dites d'extrémité du bloc semi-conducteur 14 situées de part et d'autre d'une portion centrale 140 du bloc semi-conducteur 14 et de l'ensemble des blocs 22a, ..., 22e de grille et qui sont destinées à accueillir des réservoirs de charges. Le masque diélectrique 27 est préservé sur une portion centrale 140 du bloc semi-conducteur 14 dans laquelle les ilots sont destinés à être formés.

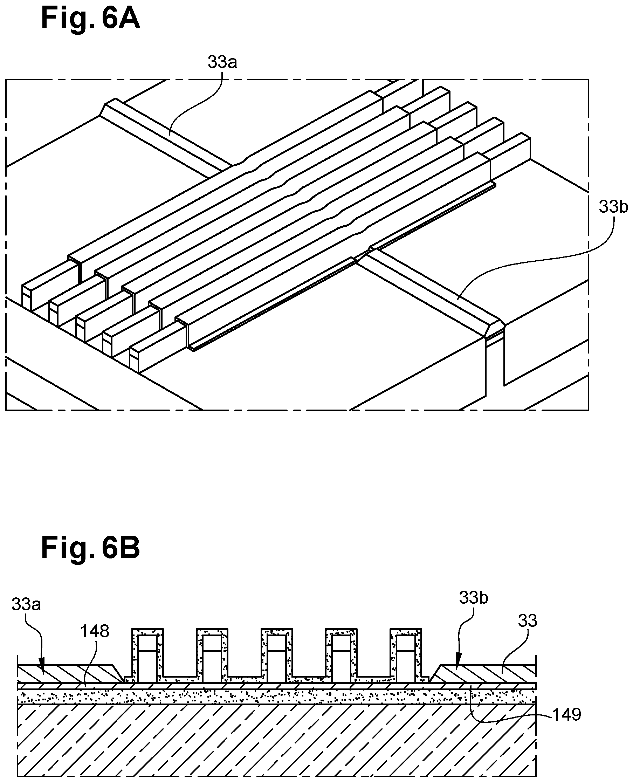

Pour compléter la formation des réservoirs de charges sur les portions 148, 149 du bloc semi-conducteur 14, on peut ensuite faire croître par épitaxie une ou plusieurs couches de matériau(x) semi-conducteur(s) 33 sur les parties 14', 14" dévoilées du bloc semi-conducteur 14 (figures 6A et 6B). Après gravure des blocs 24a, 24b, 24c, 24d, 24e de grilles, dans un cas particulier de mise en oeuvre où du diélectrique de grille recouvre les parties 14', 14" du bloc semi-conducteur 14, on retire le cas échéant, cette couche de diélectrique de grille préalablement à la croissance par épitaxie des réservoirs de charges. Pour cela, une étape de nettoyage pré-épitaxie est typiquement réalisée par exemple à base de HF dilué.

On peut effectuer en particulier réaliser une croissance épitaxiale de silicium ou un dépôt CVD (pour « chemical vapor deposition », i.e. dépôt chimique en phase vapeur) par exemple de Germanium. Un dopage est alors réalisé. Ce dopage peut être effectué par implantation ionique et/ou par dopage *in situ* effectué concomitamment à la croissance de la ou les couches de matériau(x) semi-conducteur(s) 33.

Par exemple pour former pour former de réservoirs 33a, 33b dopés selon un dopage de type N, une croissance de Si:P (silicium dopé au phosphore) peut être réalisée. Selon un autre exemple, pour former pour former des réservoirs 33a, 33b dopés selon un dopage de type P, une croissance de SiGe:B (Silicium Germanium dopé au Bore) peut être effectuée.

Du fait notamment de la présence de la couche diélectrique 27 sur une portion centrale 140 du bloc semi-conducteur 14, on évite alors un dopage de cette portion centrale 140, cette portion centrale 140 restant alors de préférence non-dopée.

Dans le cas où l'on effectue une ou plusieurs implantation(s) ionique(s) pour former les réservoirs, on utilise de préférence une résine lithographique pour masquer la portion centrale 140 et protéger cette portion de la ou les implantations.

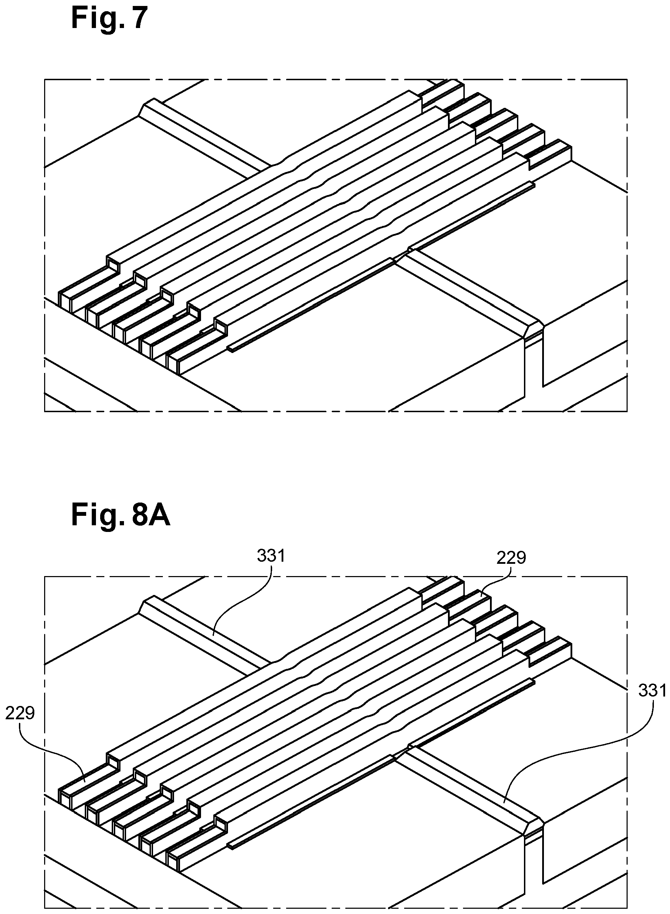

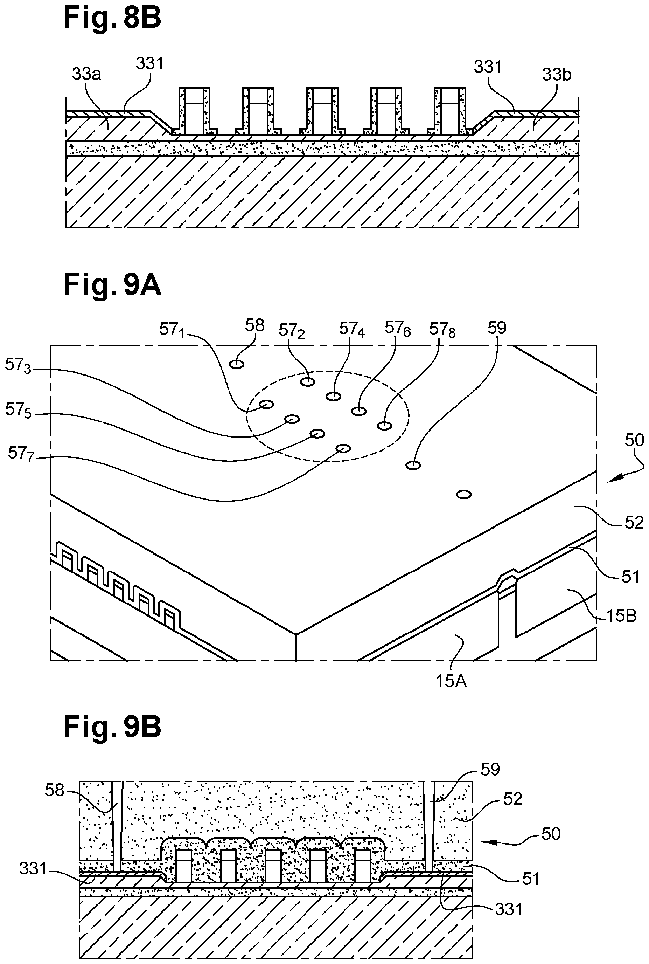

Selon une étape optionnelle illustrée sur les figures 7 et 8A-8B, on peut ensuite former des zones 331 à base d'alliage de métal et de semi-conducteur sur les réservoirs 33a, 33b dopés, afin de réaliser des contacts ohmiques sur ces réservoirs 33a, 33b. On peut également prévoir de réaliser des zones 229 d'alliage de métal et de semi-conducteur et de tels contacts ohmiques sur des extrémités des blocs 22a, ..., 22e de grille.

Pour cela, on retire (figure 7) des portions des blocs 24a, ..., 24e de masquage agencées aux extrémités des blocs 22a,...,22e de grille de manière à dévoiler une face supérieure de ces extrémités.

Puis, une étape de dépôt d'au moins une couche de métal, par exemple du Ni, du Pt, du W, du Co, du Ti, ou du V peut être effectuée. La couche de métal peut être éventuellement recouverte d'une couche d'encapsulation qui peut être métallique. Un exemple d'encapsulation est formé par dépôt de TiN, d'épaisseur par exemple de l'ordre de 10 nm.

Un traitement thermique est ensuite effectué pour réaliser la siliciuration. Un tel traitement peut être mis en oeuvre à une température comprise entre 200°C et 900°C et une durée adaptée en fonction de la température de traitement. Un retrait du métal n'ayant pas réagi peut être ensuite effectué par exemple par gravure humide en utilisant une solution de type SPM (pour « Sulfuric Peroxide Mix » autrement dit mélange de péroxyde sulfurique) à chaud. Un deuxième recuit de siliciuration peut être également effectué.

Dans l'exemple de réalisation illustré sur les figures 8A-8B, des régions 331 d'alliage de métal et de semi-conducteur, en particulier de siliciure sont ainsi formées respectivement sur les réservoirs 33a, 33b de dopants, tandis que des régions 229 d'alliage de métal et de semi-conducteur (figure 8A) sont réalisées sur les extrémités supérieures des blocs 22a,...,22e de grille.

Le dispositif quantique réalisé a ici pour particularité d'être doté d'électrodes d'échange permettant de mettre en oeuvre un couplage quantique entre des régions voisines ou adjacentes du bloc semi-conducteur 14 et destinées chacune un ilot quantique.

Ainsi, pour réaliser de telles électrodes d'échange on forme tout d'abord au préalable au moins une couche isolante 50. La couche isolante 50 formée est prévue pour recouvrir le bloc semi-conducteur 14, les desdites zones d'isolation 15A, 15B, et les blocs 22a,...,22e de grille.

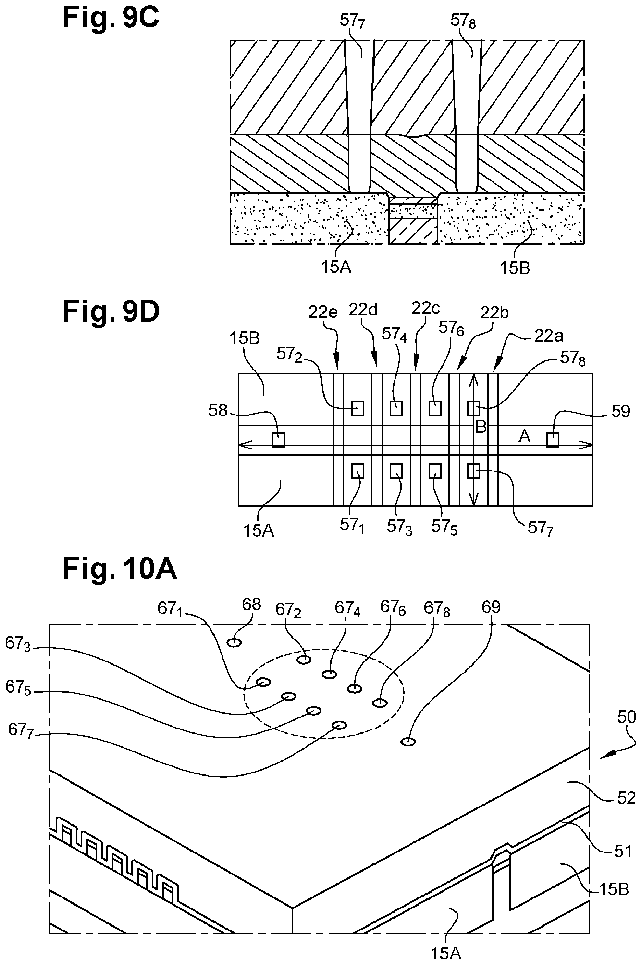

Dans l'exemple de réalisation illustré sur les figures 9A, 9B, 9C (donnant respectivement une vue en perspective, une vue en coupe selon l'axe longitudinal A donnée sur la vue de dessus de la figure 9D, une vue en coupe selon un axe B orthogonal à l'axe A), la couche isolante 50 est formée d'un empilement de plusieurs sous-couches 51, 52.

Une première sous-couche 51 en matériau isolant, par exemple du nitrure de silicium est tout d'abord réalisée et forme ici une couche d'arrêt de gravure. Un procédé de dépôt de type PECVD (« Dépôt chimique en phase vapeur assisté par plasma ») peut par exemple être employé pour former une telle couche 51 d'arrêt.

Une deuxième sous-couche 52, par exemple de l'oxyde de silicium (SiO₂) est réalisée sur la première sous-couche 51 et forme une encapsulation.

La première sous-couche 51 ou couche d'arrêt de gravure est de préférence choisie en un matériau différent de celui de la deuxième sous-couche 52 et des zones d'isolation afin de mieux contrôler la profondeur des ouvertures.

Une ou plusieurs ouvertures 57₁, 57₂, 57₃, 57₄, 57₅, 57₆, 57₇, 57₈ sont ensuite réalisées à travers la couche isolante 50 de part et d'autre du bloc semi-conducteur 14. Les ouvertures peuvent être réalisées jusqu'à atteindre les zones d'isolation 15A, 15B. La réalisation des ouvertures 57₁, 57₂, 57₃, 57₄, 57₅, 57₆, 57₇, 57₈, est effectuée typiquement par photolithographie puis par le biais d'une ou plusieurs gravures réalisées au travers d'un masquage (non représenté).

Dans l'exemple de réalisation illustré sur la figure 9B (donnant une vue en couple selon l'axe B), les ouvertures 57₅, 57₇ ont un fond situé au niveau d'une face supérieure, respectivement de la première zone d'isolation 15A et de la deuxième zone d'isolation 15B.

Selon une variante de réalisation (non représentée), on peut prévoir de prolonger ces ouvertures dans les zones d'isolation 15A, 15B. Le fond de ces ouvertures 57₅, 57₇ peut être alors situé dans l'épaisseur des zones d'isolation 15A, 15B.

Selon une autre possibilité, les ouvertures 57₁, 57₂, 57₃, 57₄, 57₅, 57₆, 57₇, 57₈ peuvent avoir un fond situé au niveau d'un matériau isolant disposé sur les zones d'isolation 15A, 15B, par exemple au niveau de la couche diélectrique 27 de masquage.

Dans l'un ou l'autre cas, le fait de réaliser les ouvertures 57₁, 57₂, 57₃, 57₄, 57₅, 57₆, 57₇, 57₈ en regard d'une zone d'isolation 15A ou 15B plutôt qu'au-dessus de la zone active permet notamment de se rapprocher de la zone active sans devoir contrôler très précisément la hauteur à laquelle se trouve leur fond.

Dans l'exemple de réalisation particulier illustré sur les figures 9A et 9D, des premières ouvertures 57₁, 57₃, 57₅, 57₇, sont formées d'un premier côté et à distance du bloc semi-conducteur 14 et ont un fond dévoilant la première zone d'isolation 15A, tandis que des deuxièmes ouvertures 57₂, 57₄, 57₆, 57₈ sont formées d'un deuxième côté et à distance du bloc semi-conducteur 14 et ont un fond dévoilant la deuxième zone d'isolation 15B. Chaque ouverture 57₁, 57₂, 57₃, 57₄, 57₅, 57₆, 57₇, 57sest dans cet exemple de réalisation particulier disposée entre une paire de blocs 22e et 22d, (resp. 22d et 22c, 22c et 22b, 22b et 22a) de blocs de grilles.

De manière avantageuse, concomitamment à la réalisation des ouvertures 57₁, 57₂, 57₃, 57₄, 57₅, 57₆, 57₇, 57₈ d'accueil des électrodes d'échange, on peut prévoir de réaliser une ou plusieurs autres ouvertures à travers la couche isolante 50 et en particulier des ouvertures 58, 59 pour réaliser des prises de contact sur les réservoirs 33a, 33b de dopants. Ces ouvertures 58, 59 ont ainsi un fond atteignant les réservoirs 33a, 33b de dopants ou les zones siliciurées formées sur ces réservoirs.

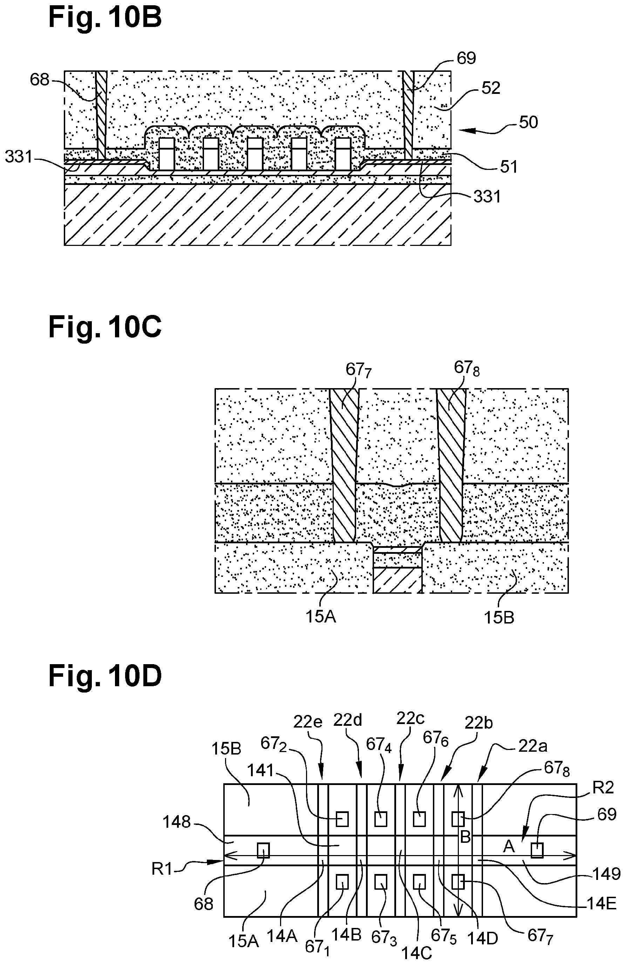

Des plots conducteurs 67₁, 67₂, 67₃, 67₄, 67₅, 67₆, 67₇, 67₈, 68, 69 sont ensuite formés par remplissage des ouvertures 57₁, 57₂, 57₃, 57₄, 57₅, 57₆, 57₇, 57₈, 58, 59 à l'aide d'un ou plusieurs matériaux conducteurs (figures 10A, 10B, 10C, 10D). Un exemple de réalisation particulier prévoit un remplissage à l'aide d'un empilement de Ti, TiN et W.

Les plots conducteurs 67₁, 67₂, 67₃, 67₄, 67₅, 67₆, 67₇, 67₈ forment ainsi chacun une électrode d'échange. Les plots conducteurs 67₁, 67₂, 67₃, 67₄, 67₅, 67₆, 67₇, 67₈, ont une extrémité inférieure 681 en contact avec une des zones d'isolation 15A, 15B.

Les électrodes d'échange 67₁, 67₂, 67₃, 67₄, 67₅, 67₆, 67₇, 67₈, sont prévues pour moduler les barrières de potentiel et par conséquent une barrière tunnel entre deux ilots quantiques adjacents ou voisins à proximité desquels ces électrodes d'échange sont disposées.

La fonction des électrodes d'échange 67₁, 67₂, 67₃, 67₄, 67₅, 67₆, 67₇, 67₈, est distincte de celle des grilles avant, ces électrodes d'échange 67₁, 67₂, 67₃, 67₄, 67₅, 67₆, 67₇, 67₈, ne sont donc pas connectées aux grilles 22a, ..., 22e avant. Les électrodes d'échange 67₁, 67₂, 67₃, 67₄, 67₅, 67₆, 67₇, 67₈, ne sont pas en contact avec le bloc semi-conducteur 14 dans lequel les ilots sont formés.

En fonction des niveaux de tensions qui leurs sont appliqués, elles modulent donc le couplage quantique entre les ilots quantiques et permettent ainsi de réaliser un contrôle de l'énergie d'échange entre ilots quantiques voisins.

Les plots conducteurs 68, 69 servent quant à eux de prises de contact sur les réservoirs 33a, 33b de dopants. On peut ainsi avantageusement réaliser de manière concomitante des prises de contacts sur les réservoirs de charges ainsi que les électrodes d'échange, et ce sans introduire d'étape supplémentaire spécifique pour réaliser ces électrodes d'échange, et en particulier sans étape de lithographie supplémentaire.

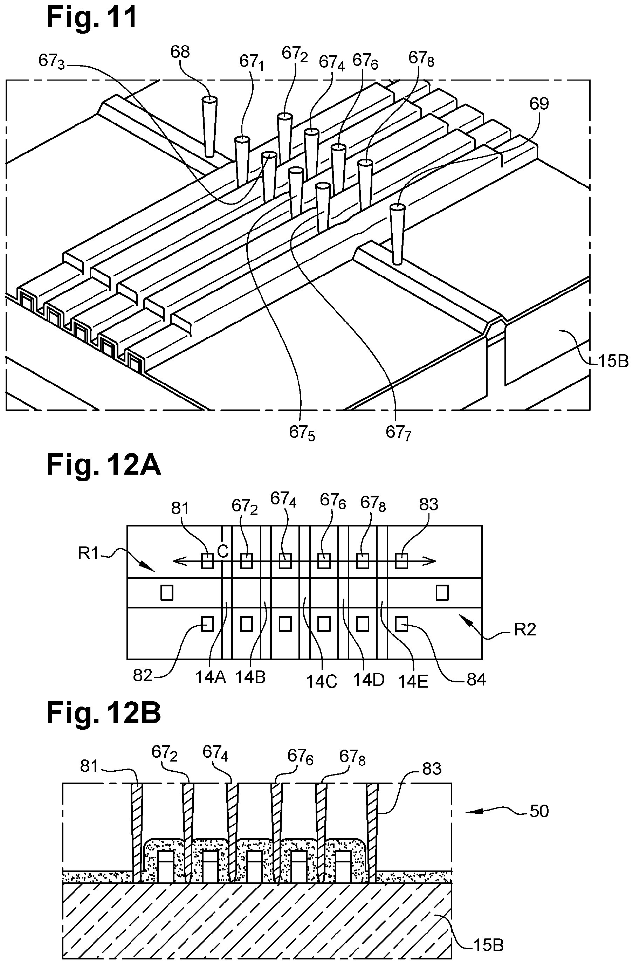

La figure 11 donne, par souci de simplification, une vue en coupe du dispositif sans une partie supérieure de la couche isolante 50 traversée par les électrodes d'échange 67₁, 67₂, 67₃, 67₄, 67₅, 67₆, 67₇, 67₈.

Comme illustré sur la figure 10D, le dispositif quantique à qubits de spin réalisé comporte une première électrode d'échange 67₁ prévue à proximité d'une première région 14A du bloc semi-conducteur 14 formant un premier ilot quantique et d'une deuxième région 14B du bloc semi-conducteur 14 formant un deuxième ilot quantique. La première électrode d'échange 67₁ permet de moduler la barrière tunnel entre la première région 14A formant le premier ilot quantique et la deuxième région 14B formant le deuxième ilot quantique. Pour disposer l'électrode d'échange on vise à s'approcher latéralement au maximum de la zone active autrement dit du bloc semi-conducteur 14, sans pour autant entrer en contact avec ce bloc, ni créer un courant de fuite entre l'électrode et la zone active. La distance séparant l'électrode et la zone active doit typiquement garantir que le courant de fuite mesuré entre ces deux éléments soit inférieur à 10 pA, pour des différences de potentiels entre ces deux éléments pouvant atteindre jusqu'à 5 Volts.

Par « à proximité », on entend ici à une distance non-nulle et de préférence inférieure à 20 nm et typiquement comprise entre 3 nm et 20 nm, de préférence 3 nm et 10 nm, avantageusement entre 3 nm et 5 nm.

Chaque électrode d'échange 67₁, 67₂, 67₃, 67₄, 67₅, 67₆, 67₇, 67₈ est également positionnée à une distance minimale Δmin non nulle du bloc semi-conducteur de préférence suffisante pour éviter qu'un courant tunnel ne passe entre cette électrode d'échange et le bloc semi-conducteur 14. Une distance Δmin d'au moins 3 nm est de préférence prévue pour cela.

La première électrode d'échange 67₁ est ici juxtaposée à une partie 141 de la portion centrale 140 dudit bloc semi-conducteur 14, de préférence non dopée, qui est agencée entre la première région 14A formant le premier ilot et la deuxième région 14B formant le deuxième ilot. Dans cette configuration particulière où les blocs 22e, 22d de grille dépassent respectivement des régions 14A, 14B, la première électrode d'échange 67₁ est agencée entre un premier bloc 22e de grille et un deuxième bloc 22d de grille, ces blocs 22e, 22d de grille s'étendant principalement dans une direction orthogonale à celle dans laquelle le bloc semi-conducteur 14 s'étend principalement. Un tel agencement permet également d'avoir des plots conducteurs proches de la zone active tout en évitant un effet d'écrantage des grilles.

On peut se servir avantageusement d'une paire d'électrodes 67₁, 67₂ pour mieux moduler les barrières tunnel entre une paire d'ilots voisins ou adjacents.

Ainsi, dans l'exemple de réalisation particulier illustré, une deuxième électrode d'échange 67₂ prévue d'un autre côté du bloc semi-conducteur 14 est également disposée à proximité de ladite première région 14A formant le premier ilot quantique et de la deuxième région 14B formant un deuxième ilot quantique. La deuxième électrode d'échange 67₂ agencée au-dessus de la deuxième zone d'isolation 15B est également disposée à une distance donnée des ilots 15A, 15B choisie pour permettre de pouvoir moduler la barrière de potentiel entre ledit premier ilot quantique et ledit deuxième ilot quantique. L'électrode d'échange 67₂ est positionnée à distance Δmin suffisante du bloc semi-conducteur pour permettre de préférence qu'aucun courant tunnel ne passe entre cette électrode 67₂ et le bloc semiconducteur 14.

Les électrodes 67₁, 67₂ d'échange peuvent être dans ce cas pilotées indépendamment l'une de l'autre, de sorte que la première électrode 67₁ peut être mise à un premier potentiel tandis que la deuxième électrode 67₂ est mise à un deuxième potentiel différent du premier potentiel. Ainsi, les électrodes 67₁, 67₂ peuvent être indépendantes l'une de l'autre, autrement dit non connectées ou non reliées entre elles, et aptes à recevoir des potentiels distincts.

Une troisième électrode 67₃ d'échange et une quatrième électrode 67₄ d'échange sont ici disposées de part et d'autre d'une partie 142 du bloc semi-conducteur 14 située entre le deuxième ilot quantique, et un troisième ilot formé dans une troisième région 14C de ce bloc semi-conducteur 14. La troisième électrode 67₃ d'échange et la quatrième électrode 67₄ disposées respectivement sur la première zone d'isolation 15A et sur la deuxième zone d'isolation 15B, sont prévues, en fonction des potentiels respectifs qui leurs sont appliqués, pour permettre de pouvoir moduler la barrière tunnel entre le deuxième ilot quantique formé dans la région 14B et le troisième ilot quantique formé dans la région 14C.

Dans l'exemple de réalisation illustré, les électrodes 67s, 67₆ disposées entre la région 14C et la région 14D, sont prévues pour moduler la barrière tunnel entre le les ilots quantiques voisins formés respectivement dans ces région 14C, 14D. De même, les électrodes 67₇, 67₈ permettent de moduler la barrière tunnel entre un ilot quantique formé dans une région 14D et un ilot quantique adjacent, ici un ilot quantique d'extrémité de la succession ou série d'ilots formés dans la portion centrale du bloc semi-conducteur 14.

Outre une ou plusieurs électrodes d'échanges entre ilots, le dispositif quantique peut être également doté d'une ou plusieurs électrodes d'échanges supplémentaires cette fois entre au moins un ilot quantique 14A ou 14E situé à une extrémité de la succession d'ilots 14A, 14B, 14C, 14D, 14E et un des réservoirs R1, R2 de dopants situés de part et d'autre de cette succession d'ilots et formé dans et/ou à partir du bloc semi-conducteur 14.

Dans un exemple de réalisation illustré sur les figures 12A, 12B (donnant respectivement une vue de dessus et une vue en coupe selon un axe C) on prévoit ici une paire d'électrodes d'échanges 81, 82, supplémentaire pour moduler la barrière de potentiel entre le premier ilot quantique 14A et un premier réservoir R1 de dopants formé dans ou sur une portion d'extrémité 148 du bloc semi-conducteur 14. Une autre paire supplémentaire d'électrodes d'échanges 83, 84, peut être également prévue pour moduler la barrière de potentiel entre cette fois un autre ilot quantique 14E d'extrémité et un deuxième réservoir R2 de dopants située à l'opposé du premier réservoir R1 dans l'autre portion 149 d'extrémité du bloc semi-conducteur 14.

Les électrodes d'échanges 81, 82, 83, 84 supplémentaires sont typiquement formées lors des mêmes étapes de procédé que les électrodes d'échanges 67₁, 67₂, 67₃, 67₄, 67₅, 67₆, 67₇, 67₈, telles que décrites précédemment en liaison avec les figures 9A-9D et 10A-10D.

Pour réaliser ces électrodes d'échanges 81, 82, 83, 84, on forme en particulier des ouvertures dans la couche isolante 50 atteignant chacune la zone d'isolation 15A ou la zone d'isolation 15B, puis l'on remplit ces ouvertures d'au moins un matériau conducteur pour former des plots conducteurs dans ces ouvertures.

Les électrodes d'échanges 81, 82, 83, 84 sont disposées sur une zone d'isolation 15A ou 15B et suffisamment proche du réservoir de dopant R1 ou R2, pour en fonction du niveau de potentiel qui leur est appliqué, permettre de moduler le couplage entre ce réservoir de dopants R1, R2 et l'ilot quantique 15A, 15E d'extrémité juxtaposé à ce réservoir R1, R2.

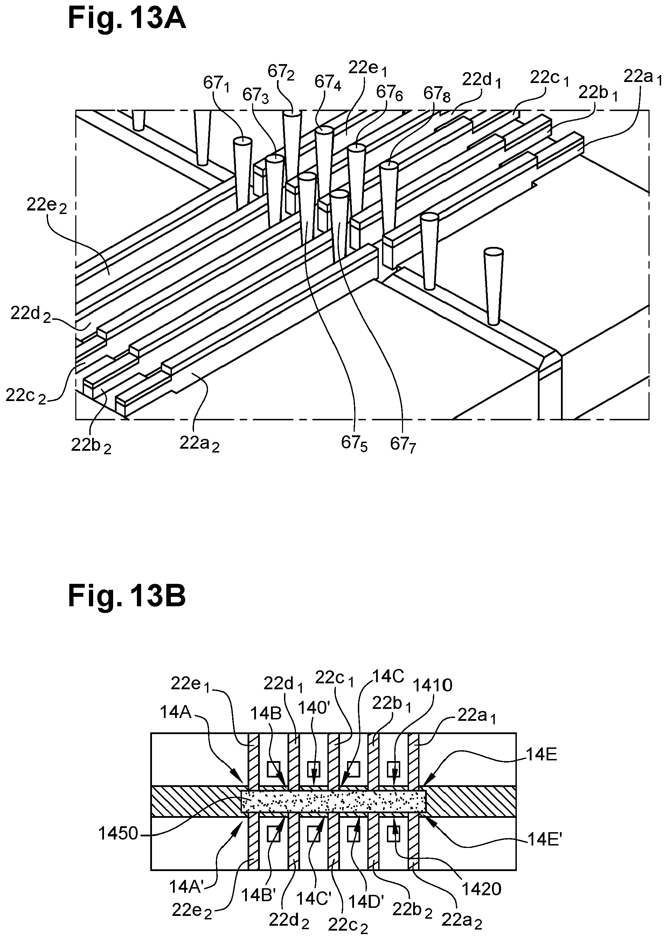

Une variante de réalisation est donnée sur les figures 13A-13B. Le bloc semi-conducteur 14 a ici une portion centrale 140' de configuration différente de celle décrite précédemment et formée d'un premier barreau semi-conducteur 1410 dans lequel une rangée d'ilots quantiques 14A, 14B, 14C, 14D, 14E est prévue et un deuxième barreau semi-conducteur 1420, dans lequel une autre rangée d'ilots 14A', 14B', 14C', 14D', 14E'

Les barreaux semi-conducteurs 1410, 1420 ont une forme oblongue par exemple parallélépipédique et sont séparés entre eux par l'intermédiaire d'une région 1450 typiquement en matériau isolant.

Cette configuration de la portion centrale 140 du bloc semi-conducteur peut être obtenue en réalisant une tranchée dans ce dernier, cette tranchée pouvant être alors remplie de matériau isolant.

Au-dessus de chaque ilot de la première rangée, une grille 221 de contrôle avant est agencée, et face à cette grille 221, au-dessus de chaque ilot de la deuxième rangée d'ilots de détection, une grille 222 de contrôle est prévue.

Les ilots du premier barreau 1410 peuvent être prévus pour former une première rangée de qubits de donnée, tandis que les ilots du deuxième barreau 1420 peuvent former une deuxième rangée d'éléments de détection pour la lecture de valeur codée des qubits de donnée de la première rangée.

Dans l'un ou l'autre des exemples de réalisation décrits précédemment, le bloc semi-conducteur dans lequel les ilots quantiques sont formés est réalisé à partir de la couche superficielle d'un substrat, en particulier un substrat semi-conducteur sur isolant. Toutefois, il est également possible de partir d'un substrat différent, par exemple un substrat massif (« bulk » selon la terminologie anglo-saxonne) pour former ce bloc.

Le ou les blocs semi-conducteurs dans lequel ou dans lesquels les ilots quantiques sont formés peuvent être également formés dans une ou plusieurs couches semi-conductrices distinctes d'une couche superficielle semi-conductrice d'un substrat. Ainsi, il est en variante possible de prévoir de former le bloc semi-conducteur d'accueil d'ilots quantiques par gravure d'un motif réalisé à partir d'une ou plusieurs couches ou zones formées par épitaxie.

Selon une mise en oeuvre particulière, le bloc semi-conducteur dans lequel on prévoit les ilots quantiques peut être sous forme d'un barreau et mis en oeuvre d'une manière semblable à celle dont on réaliser le barreau semi-conducteur (« fin » selon la terminologie anglo-saxonne) d'un transistor de type finFET.

Un dispositif quantique mis en oeuvre suivant l'invention n'est pas limité à un nombre d'ilots quantiques et de grilles avant tel que donné par exemple sur les figures 12A-12B. Un nombre N (avec N un nombre entier qui peut être supérieur à 5) plus important de grilles et d'ilots quantiques peut être prévu. Dans ce cas, on prévoit typiquement au moins N-1 électrodes et de préférence N-1 paires d'électrodes d'échanges disposées entre chaques paires d'ilôt quantiques voisins.

Un dispositif tel que décrit précédemment peut être pourvu d'un circuit électronique de pilotage des Qubits et s'adapte à la mise en oeuvre sur le même substrat de transistors pour ce circuit de pilotage. Les transistors du circuit de pilotage peuvent être en technologie CMOS (« Complementary metal-oxide-semiconductor « semi-conducteur à oxyde métallique complémentaire »), et en particulier Cryogenic CMOS, or cryo-CMOS, fonctionnant à basse température et typiquement inférieure à 1 Kelvin afin de préserver au mieux les états quantiques des qubits.

## Revendications

1. Dispositif électronique quantique comprenant :
- un substrat (10) revêtu d'au moins un bloc semi-conducteur (14), ledit bloc semi-conducteur s'étendant principalement dans une première direction, le bloc semi-conducteur (14) comprenant une couche semi-conductrice (13) ;
- des zones d'isolation (15A, 15B) agencées de part et d'autre de la couche semi-conductrice (13) dudit bloc semi-conducteur (14),
- une pluralité de grilles (22a, 22b, 22c, 22d, 22e) avant, chaque grille avant comprenant une partie s'étendant sur des régions (14A, 14B, 14C, 14D, 14E) de la couche semi-conductrice (13) dudit bloc semi-conducteur (14), chacune desdites régions formant un ilot quantique, chaque grille avant comprenant une autre partie s'étendant sur une des zones d'isolation (15A, 15B);
- une ou plusieurs électrodes d'échange (67₁, 67₂, 67₃, 67₄, 67₅, 67₆, 67₇, 67₈,), pour moduler la barrière tunnel entre ilots quantiques voisins ou adjacents, lesdites une ou plusieurs électrodes d'échange (67₁, 67₂, 67₃, 67₄, 67₅, 67₆, 67₇, 67₈,) sont agencée(s) entre deux grilles avant, en regard et au-dessus d'une desdites zones d'isolation et chaque électrode d'échange (67₁, 67₂, 67₃, 67₄, 67₅, 67₆, 67₇, 67₈,) est dotée d'une extrémité inférieure en contact directement avec un matériau isolant de cette zone d'isolation ou en contact directement avec un matériau isolant disposé sur cette zone d'isolation.

2. Dispositif électronique quantique selon la revendication 1, dans lequel au moins une première électrode d'échange (67₁) parmi lesdites électrodes d'échange s'étend au-dessus de la première zone d'isolation (15A) et à distance d'une première région (14A) dudit bloc semi-conducteur (14) formant un premier ilot quantique, la première électrode d'échange (67₁) étant prévue à distance d'une deuxième région (14B) dudit bloc semi-conducteur (14) formant un deuxième ilot quantique et de sorte à permettre de moduler une barrière tunnel entre ledit premier ilot quantique et ledit deuxième ilot quantique.

3. Dispositif selon la revendication 2, dans lequel ladite deuxième région (14B) dudit bloc semi-conducteur (14) forme un deuxième ilot quantique, la première électrode d'échange (67₁) étant juxtaposée à une partie (141) dudit bloc semi-conducteur (14) agencée entre ladite première région (14A) et ladite deuxième région (14B) dudit bloc semi-conducteur (14).

4. Dispositif selon l'une des revendications précédentes, comprenant au moins une deuxième électrode d'échange (67₂) agencée au-dessus d'une deuxième zone d'isolation (15B) et à proximité de ladite première région (14A) formant un premier ilot quantique et d'une deuxième région (14B) formant un deuxième ilot quantique de sorte à permettre de moduler la barrière tunnel entre ledit premier ilot quantique et ledit deuxième ilot quantique, ladite deuxième électrode d'échange (67₂) étant formée d'un deuxième plot conducteur ayant une extrémité dite « inférieure » disposée en contact avec une deuxième zone d'isolation (15B) ou avec un matériau isolant formé sur ladite deuxième zone d'isolation.

5. Dispositif selon la revendication 4, dans lequel la première électrode d'échange (67₁) est agencée entre une première (22e) grille recouvrant ladite première région et une deuxième (22d) grille recouvrant ladite deuxième région, la première grille et la deuxième grille s'étendant principalement dans une deuxième direction orthogonale à la première direction en regard de la première zone d'isolation (15A).

6. Dispositif selon l'une des revendications 4 ou 5, comprenant en outre au moins une autre électrode d'échange (67₃, 67₄) pour moduler la barrière tunnel entre ledit deuxième ilot quantique et un troisième ilot quantique formé dans une troisième région (14C) dudit bloc semi-conducteur (14), ladite autre électrode d'échange (67₃, 67₄) étant formée d'un troisième plot conducteur, ledit troisième plot conducteur étant formé en regard et au-dessus de la première zone d'isolation (15A) ou la deuxième zone d'isolation (15B).

7. Dispositif selon l'une des revendications 2 à 6, dans lequel la première électrode d'échange (67₁) est prévue pour contrôler la barrière tunnel entre ledit premier ilot quantique et ledit deuxième ilot quantique, le dispositif étant doté en outre d'au moins une électrode d'échange supplémentaire (81, 82, 83, 84) prévue pour moduler une barrière tunnel entre un desdits ilots quantique (14A, 14E) et un réservoir de dopants (33a, 33b) formé sur et/ou dans une portion d'extrémité (148, 149) du bloc semi-conducteur (14).

8. Dispositif selon la revendication 5, dans lequel une deuxième électrode d'échange (67₂) est disposée entre la deuxième grille recouvrant ladite deuxième région et une troisième grille, la première électrode d'échange (67₁) et la deuxième électrode d'échange étant indépendantes l'une de l'autre et non connectées entre elles.

9. Dispositif selon l'une des revendications 1 à 8, dans lequel ladite extrémité inférieure de chaque électrode d'échange est en contact avec une couche (51) d'arrêt de gravure ou une couche diélectrique (27) dans laquelle des espaceurs isolants des grilles avant sont formés.

10. Dispositif selon l'une des revendications 1 à 9, dans lequel ledit bloc semi-conducteur (14) est formé dans une couche semi-conductrice superficielle (13) d'un substrat (10) de type semi-conducteur sur isolant, ou repose sur un substrat semi-conducteur massif.

11. Dispositif selon l'une des revendications 1 à 10, comprenant en outre des réservoirs de charge formés sur ou dans ledit bloc semi-conducteur (14),
le dispositif étant avantageusement doté d'une pluralité d'électrodes de réservoir de charge, chacune contactant un réservoir de charge formé sur et/ou dans ledit bloc semi-conducteur (14).

12. Procédé de fabrication d'un dispositif quantique selon l'une des revendications 1 à 11, le procédé comprenant, dans cet ordre, des étapes de :
- formation sur ledit substrat (10) ledit bloc semi-conducteur (14), et des zones d'isolation (15A, 15B) de part et d'autre dudit bloc semi-conducteur (14), puis
- formation des blocs (22a, 22b, 22c, 22d, 22e) de grille sur le bloc semi-conducteur (14), lesdits blocs (22a, 22b, 22c, 22d, 22e) de grille s'étendant principalement dans une direction orthogonale à une direction principale dans laquelle s'étend ledit bloc semi-conducteur (14), puis,
- formation desdites une ou plusieurs électrodes d'échange par :
• dépôt d'une couche isolante (50) recouvrant ledit bloc semi-conducteur (14), lesdites zones d'isolation (15A, 15B) et les blocs (22a, 22b, 22c, 22d, 22e) de grille,
• réalisation d'une ou plusieurs ouvertures (57₁, 57₂, 57₃, 57₄, 57₅, 57₆, 57₇, 57₈, 58, 59) traversant ladite couche isolante (50), au moins une première ouverture (57₁) traversant ladite couche isolante (50) et étant réalisée de sorte à atteindre la première zone d'isolation (15A) ou un matériau isolant formé sur la première zone d'isolation,
• dépôt d'au moins un matériau conducteur dans lesdites ouvertures (57₁, 57₂, 57₃, 57₄, 57₅, 57₆, 57₇, 57₈, 58, 59).

13. Procédé selon la revendication 12, comprenant en outre, préalablement à la formation de la couche isolante (50), des étapes de :
- dépôt d'au moins une couche diélectrique (27),
- gravure de ladite couche diélectrique (27) sur des portions d'extrémité (148, 149) du bloc semi-conducteur (14) agencées de part et d'autre de l'ensemble des blocs (22a, 22b, 22c, 22d, 22e) de grille et de sorte à conserver ladite couche diélectrique (27) sur une portion centrale (140) dudit bloc semi-conducteur et à former des espaceurs isolants contre les blocs (22a, 22b, 22c, 22d, 22e) de grille.

14. Procédé selon la revendication 13, comprenant en outre, après la gravure de ladite couche diélectrique (27) et préalablement à la formation de la couche isolante (50), la formation de régions dopées (33a, 33b) sur lesdites portions (148, 149) du bloc semi-conducteur (14) agencées de part et d'autre de l'ensemble des blocs (22a, 22b, 22c, 22d, 22e) de grille.

15. Procédé selon l'une des revendications 12 à 14, dans lequel parmi lesdites ouvertures, au moins une autre ouverture (58, 59) dévoile une région dopée (33a, 33b) du bloc semi-conducteur (14) ou formée sur ledit bloc semi-conducteur (14).
